# EUROPEAN PATENT SPECIFICATION

(11) **EP 2 521 169 B1**
(45) Date of publication and mention of the grant of the patent: **13.05.2015**
(21) Application number: 09852759.1
(22) Date of filing: 31.12.2009
(51) Int. Cl.: H01L 25/03, H01L 25/075, H01L 33/50, G09F 9/33, F21K 2/06, F21V 9/02, F21Y 101/02, C09K 11/59, C03C 14/00, C03C 17/22, F21V 3/04, F21V 9/16

(54) **WHITE LIGHT LUMINESCENT DEVICE BASED ON PURPLE LIGHT LEDS**
AUF PURPURLICHT-LED BASIERENDE WEISSLICHT-LUMINESZENZVORRICHTUNG
DISPOSITIF LUMINESCENT À LUMIÈRE BLANCHE BASÉ SUR DES DEL À LUMIÈRE VIOLETTE

(43) Date of publication of application: 07.11.2012
(73) Proprietor: Ocean's King Lighting Science&Technology Co., Ltd., Guangdong 518052 (CN)
(72) Inventor: ZHOU, Mingjie, Guangdong 518052 (CN); MA, Wenbo, Guangdong 518052 (CN); QIAO, Yanbo, Guangdong 518052 (CN); SHI, Zhaopu, Guangdong 518052 (CN); LI, Qingtao, Guangdong 518052 (CN)
(74) Representative: Johnson, Richard Alan
(86) International application number: PCT/CN2009/076373
(87) International publication number: WO 2011/079474

(56) References cited:
- EP-A1- 1 830 415
- CN-A- 1 547 266
- CN-A- 1 752 041
- CN-A- 1 752 041
- CN-A- 101 169 235
- CN-Y- 2 292 303
- CN-Y- 2 486 834
- US-A1- 2003 075 705
- US-A1- 2004 032 204
- US-A1- 2005 057 145
- US-A1- 2005 218 780
- US-A1- 2006 027 781
- US-A1- 2007 104 861
- US-B1- 6 255 670
- LIU, JI ET AL.: 'Progress in Research on White Light Emitting Diode and its Phosphors.' MATERIALS REVIEW. vol. 21, no. 8, August 2007, ISSN 1005-023X pages 116 - 120

## Description

### FIELD OF THE INVENTION

The present invention relates to a white light emitting device in the lighting technical field, and more particularly to a white light emitting device based on purple light emitting diode (purple light LED).

### BACKGROUND OF THE INVENTION

Recently, luminescent glass has been a development of the new luminescent material. Generally, a series of high silica luminescent glass of luminescent materials can be efficiently excited by UV (ultraviolet) rays, and the luminescence spectra thereof can cover the visible region. A conventional preparation method for the luminescent material of the series of high silica luminescent glass includes the following steps: using porous glass, in which SiO₂ content is more than 95wt% (weight percent), as a substrate; immersing the porous glass in aqueous solution, acid solution or organic solution, wherein the aqueous solution, the acid solution or the organic solution contains active ions (e.g. Eu, Ce, Tb, Cu, Zn, Sn, etc.); and sintering the porous glass in air or in reducing atmosphere at high temperature (1050 °C and above). US 2005/057145 discloses white light emitting devices using purple light.

At present, using combinations of purple light LED chips and three-color phosphor to get white light emission has become a trend of white light emitting device. This combination has higher color rendering, compared to the combination of blue LED (460nm) and YAG: Ce yellow phosphor which can generate white light as well. However, the converting efficiency of the three-color phosphor, which is suitable for purple light LED, is not high enough. Therefore, it is needed to improve the converting efficiency of the three-color phosphor.

### DISCLOSURE OF THE INVENTION

One technical problem of the present invention be solved is: providing a white light emitting device having higher converting efficiency and color rendering coefficient, compared to the present combinations of purple light LED chips and three-color phosphor, alleviating the drawback of low converting efficiency for light emission of the three-color phosphor.

The technical solution to solve the technical problem in the present invention is: providing a white light emitting device based on purple light LED, wherein the white light emitting device includes a housing, a support plate, at least one purple light LED semiconductor light source, and a piece of high silica luminescent glass. The support plate is received in the housing. The at least one purple light LED semiconductor light source, which has emission wavelength within 210nm-410nm, is positioned on the support plate. The piece of high silica luminescent glass doped with Eu ions is opposite to the purple light LED semiconductor light source. One surface of the high silica luminescent glass away from the purple light LED semiconductor light source is coated with a phosphor layer, which is formed with a selection from a mixture of yellow phosphor and red phosphor, a mixture of green phosphor and red phosphor, and yellow phosphor.

The method for preparing the high silica luminescent glass doped with Eu ions includes the following steps: choosing high silica porous glass with aperture within several nanometers to dozens of nanometers and the volume of the micropores thereof is 25-40% of the total volume of the glass; immersing the high silica porous glass in a solution with Eu ions concentration ranging 0.005 - 0.1M, wherein the dissolvent thereof may be aqueous solution or ethanol solution etc.; taking out the soaked glass to be dried, and then sintering the glass in an environment with temperature at 1050 °C-1200 °C, to obtain the compact high silica luminescent glass doped with Eu ions.

The thickness of the high silica luminescent glass doped with Eu ions is 0.1mm-50mm.

The high silica luminescent glass doped with Eu ions excited by 240nm-410nm rays can emits blue light with wavelength within 430-460nm.

The yellow phosphor is a kind of material which can absorb blue light which is emitted from the high silica luminescent glass doped with Eu ions, and then emits yellow light. The maximum emission peak of the yellow phosphor is at 530nm-590nm. Advantageously, the yellow phosphor is silicate phosphor which is activated by a wide band, or/and is a series of rare-earth garnet phosphor which is activated by Cerium. For example, the phosphor can be chosen from YAG: Ce system (e.g. the material made by Dalian Luming LED Technology Co., Ltd., with product No. LMY-60-C), or silicate system (e.g. the material produced by Dalian Luming LED Technology Co., Ltd, with product No. LMS-550).

The green phosphor is a kind of material which can absorb blue light which is emitted from the high silica luminescent glass doped with Eu ions, and then emits green light. The maximum emission peak of the green phosphor is at 490nm-525nm. Advantageously, the green phosphor is chloride silicate phosphors or Ca₃Sc₂Si₃O₁₂: Ce green light luminescent material. For example, the green phosphor may be chloride silicate phosphors which satisfy the chemical formula as Ca_{8-x-y}EuₓMn_{y}M_{g} ( SiO₄) ₄Cl₂, or Ca₃Sc₂Si₃O₁₂: Ce phosphor.

The red phosphor is a kind of material which can absorb blue light which is emitted from the high silica luminescent glass doped with Eu ions, and then emits red light. The red phosphor is sulfide phosphor or nitride phosphor, with a maximum emission peak at 595nm-680nm. The sulfide phosphor can be selected from, e.g. CaS : Eu or SrS: Eu and so on. The nitride phosphor can be a material with product No. as ZYP630, which is produced by Beijing Nakamura-Yuji Science and Technology Co., Ltd.

In the mixture of yellow phosphor and red phosphor, the weight ratio of the yellow phosphor and the red phosphor is 1:0.1~1:1.

In the mixture of green phosphor and red phosphor, the weight ratio of the green phosphor and the red phosphor is 1:0.1~1:1.

The present invention employs at least one purple light LED semiconductor light source positioned on the support plate, and having emission wavelength within 210nm-410nm. The purple light LED semiconductor light source emits UV light, and the UV light irradiates on the high silica luminescent glass doped with Eu ions. As such, the high silica luminescent glass doped with Eu ions can convert the UV light emitted from the purple light LED, which is in 240nm-410nm, to blue light which has a maximum emission peak at about 450nm. The absorption of UV light and the emission intensity of the blue light can be controlled by adjusting the doping concentration of Eu in the high silica luminescent glass and the thickness of the glass. Then, the blue light activates one of the mixture of yellow phosphor and red phosphor, the mixture of green phosphor and red phosphor, and only the yellow phosphor which are suitably excited by 450nm. The blue light and the light activated from the phosphor are compounded, forming white light with different color temperature and color rendering index, thus synthesizing white light which has higher color rendering coefficient.

Other aspects, features, and advantages of this invention will become apparent from the following detailed description when taken in conjunction with the accompanying drawings, which are a part of this disclosure and which illustrate, by way of example, principles of this invention.

### BRIEF DESCRIPTION OF THE DRAWINGS

The accompanying drawings facilitate an understanding of the various embodiments of this invention. In such drawings:
FIG. 1 is the excitation and emission spectra of high silica luminescent glass doped with Eu ions, according to one embodiment;
FIG. 2 is a schematic diagram of a white light emitting device based on purple light LED, according to one embodiment.
FIG. 3 is the excitation and emission spectra of the yellow light phosphor LMS-550.

### DETAILED DESCRIPTION OF ILLUSTRATED EMBODIMENTS

Various preferred embodiments of the present invention will now be described with reference to the figures, wherein like reference numerals designate similar parts throughout the various views. As indicated above, the present invention is designed to improve the white light emitting device based on purple light LED.

A method for preparing blue light high silica luminescent glass doped with Eu ions is described as below.

First of all, the raw material containing Eu ions are processed into aqueous solution, nitric acid solution, sulfuric acid solution, ethanol solution, or acetone solution each containing Eu ions. Then the high silica porous glass with a SiO₂ content more than 95wt% is immersed in the solutions described above, wherein the concentration of the Eu ions is 0.005--0.1M. It is noted that the high silica porous glass can be immersed in different solution with different concentration of Eu ions, according to the absorption of ultraviolet (UV) light thereof and a requirement of the emission intensity of the blue light, for obtaining high silica porous glass with different content of Eu ions to control the absorption of UV light therein and the emission intensity of the blue light. The soaked high silica porous glass is took out to be dried and then placed in a high temperature furnace. In a reducing atmosphere with 95% of N₂ (Nitrogen) and 5% of H₂ (hydrogen), the high silica porous glass is sintered at high temperature of 1050 °C-1200 °C for 2 hours. After that, the high-temperature furnace is turned off, so that the glass is cooled down by following the temperature of the furnace. Finally, the blue light high silica luminescent glass doped with Eu ions is produced.

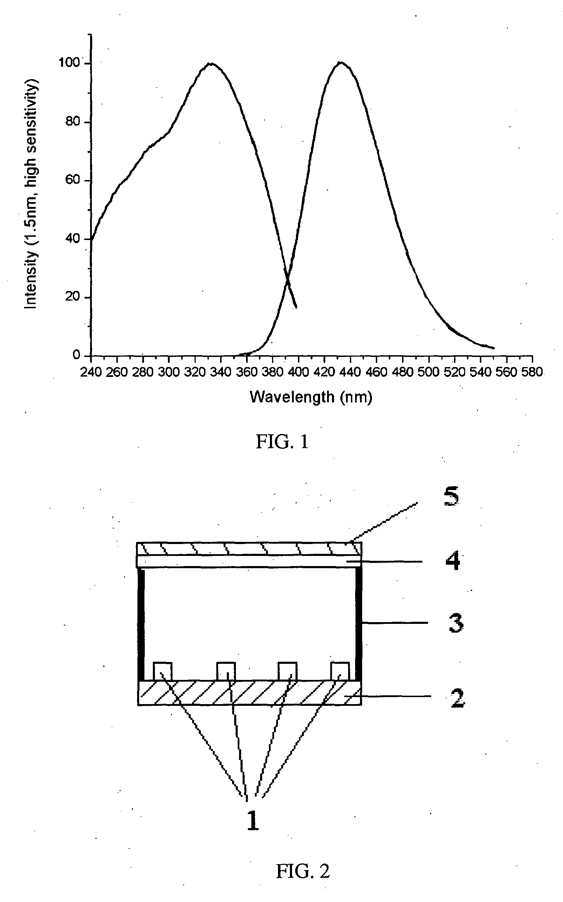

FIG. 1 is the excitation and emission spectra of high silica luminescent glass doped with Eu ions. It can be seen from FIG. 1 that the blue light high silica luminescent glass can be excited by UV light with wavelength within 240nm-410nm obviously, and generate a strong blue light emission with light wavelength in about 450nm.

In a first embodiment, as shown in FIG. 2, a white light emitting device based on purple light LED includes a housing 3 with a support plate 2 received therein. At least one purple light LED semiconductor light source 1 with emission wavelength range within 210nm--410nm is positioned on the support plate 2. In this embodiment, four purple light LED semiconductor light sources 1 are employed. The housing 3 also receives a piece of high silica luminescent glass 4 doped with Eu ions opposite to the purple light LED semiconductor light source 1. In this embodiment, the thickness of the high silica luminescent glass 4 is 0.1mm-50mm. The purple light LED semiconductor light source 1 is spaced apart from the high silica luminescent glass 4. One surface of the high silica luminescent glass 4 away from the purple light LED semiconductor light source 1 is coated with a phosphor layer 5, made of a mixture of yellow phosphor and red phosphor, a mixture of green phosphor and red phosphor, or yellow phosphor. In some embodiments, the phosphor layer 5 can be formed by dispersing the above-mentioned phosphor in a transparent epoxy resin, in a way of spin coating or spray coating.

The yellow, green, red phosphor suitable for 450nm excitation used in the present invention can be bought from commercial market and used directly. However, it is noted that the invention is not limited to such implementations.

In a second embodiment, the yellow phosphor in the phosphor layer is silicate phosphor which can be activated by a wide band. In the present embodiment, the silicate phosphor may be chosen from the LMS series with rare-earth activated silicate phosphor (product No. is LMS-550), produced by Dalian Luming LED Technology Co., Ltd. Because the structure of the device, the choice of the purple light LED, and the way for coating phosphor are almost the same to the first embodiment mentioned above, it will not be repeated here.

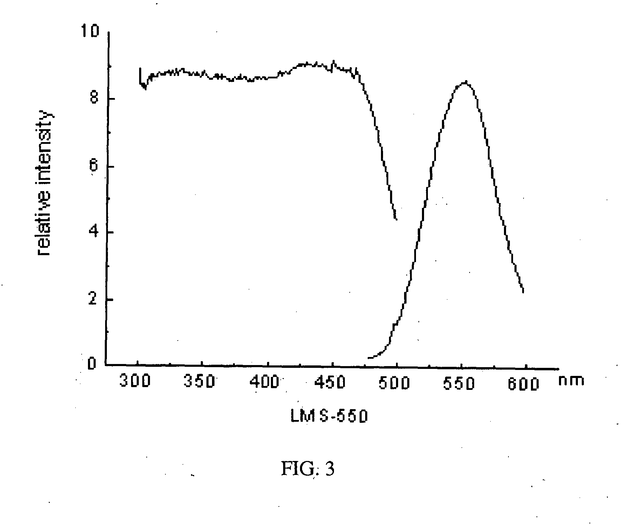

FIG. 3 is the excitation and emission spectra of the yellow light phosphor LMS-550. It can be seen from FIG. 3: the phosphor LMS-550 can be efficiently excited by blue-violet light from about 300nm to 460nm and emits yellow light around 550nm. In this embodiment, the high silica luminescent glass 4 doped with Eu ions can be efficiently excited by the UV light at 365nm emitted from the purple light LED, and emits blue ray at 442nm. Part of the blue ray emitted from the high silica luminescent glass 4 doped with Eu ions can further excited the phosphor LMS-550, coated on the high silica luminescent glass 4, and the phosphor LMS-550 emits yellow light, thus the remaining blue light and the emitted yellow light can compound to form the white light.

In a third embodiment, the yellow phosphor in the phosphor layer 5 is chosen from the series of rare-earth garnet phosphor which can be activated by Ce (Cerium). In this embodiment, the yellow phosphor is a product of Dalian Luming LED Technology Co., Ltd. (i.e. product No. LMY-60-C). Since the device structure, the choice of the purple light LED and the way for coating phosphor are the same to the first embodiment, it can be omitted here.

In a fourth embodiment, the phosphor layer 5 includes the mixture of yellow phosphor and red phosphor, to enhance the color rendering of the white light emitting device. The weight ratio of the yellow phosphor and the red phosphor is 1:0.4. The yellow phosphor may be chosen from the LMS series with rare-earth activating silicate phosphor (product No. LMS-550), produced by Dalian Luming LED Technology Co., Ltd. The red phosphor is selected from Beijing Nakamura-Yuji Science and Technology Co., Ltd, with product No. ZYP650H in this embodiment. Since the structure of the device, the choice of the purple light LED, and the way for coating phosphor are all the same to the first embodiment which is already mentioned above, it will not be repeated here.

In a fifth embodiment, for the purple light LED-based white light emitting device, the phosphor layer 5 includes the mixture of green phosphor and red phosphor mixture, to enhance the color rendering of the white light emitting device. The weight ratio of the green phosphor and the red phosphor is 1:0.6. The green phosphor has an emission maximum at 490nm-525nm. The green phosphor can be selected from the products of LMS series of rare-earth activating silicate phosphor (product number LMS-520), come from Dalian Luming LED Technology Co., Ltd. The red phosphor is sulfide phosphor or nitride phosphor which has an emission maximum at 595nm~680nm. The red phosphor can be the product ZYP650H, from Beijing Nakamura-Yuji Science and Technology Co., Ltd. Since the structure of the device, the choice of the purple light LED, and the way for coating phosphor are all the same to the first embodiment which is already mentioned above, it would not be repeated here.

In a sixth embodiment, for the white light emitting device based on purple light LED, the phosphor layer 5 includes the mixture of green phosphor and red phosphor, to enhance the color rendering of the white light emitting device. The weight ratio of the green phosphor and the red phosphor is 1:0.5. The green phosphor is Ca_{8-x-y}EuₓMn_{y}Mg (SiO₄) ₄Cl₂. The red phosphor is ZYP650H, produced by Beijing Nakamura-Yuji Science and Technology Co., Ltd. Since the structure of the device, the choice of the purple light LED, and the way for coating phosphor are all the same to the first embodiment which is already mentioned above, it would not be repeated here.

In a seventh embodiment, for the white light emitting device based on purple light LED, the phosphor layer 5 includes the mixture of green phosphor and red phosphor, to enhance the color rendering of the white light emitting device. The weight ratio of the green phosphor and the red phosphor is 1: 0.2. The green phosphor is Ca₃Sc₂Si₃O₁₂: Ce. The red phosphor is CaS: Eu. Since the structure of the device, the choice of the purple light LED, and the way for coating phosphor are all the same to the first embodiment which is already mentioned above, it would not be repeated here.

In an eighth embodiment, for the white light emitting device based on purple light LED, the phosphor layer 5 includes the mixture of green phosphor and red phosphor, to enhance the color rendering of the white light emitting device. The weight ratio of the green phosphor and the red phosphor is 1: 0.1. The green phosphor is Ca₃SC₂Si₃O₁₂: Ce. The red phosphor is SrS: Eu. Since the structure of the device, the choice of the purple light LED, and the way for coating phosphor are all the same to the first embodiment which is already mentioned above, it would not be repeated here.

In a ninth embodiment, for the white light emitting device based on purple light LED, the phosphor layer 5 includes the mixture of green phosphor and red phosphor, to enhance the color rendering of the white light emitting device. The weight ratio of the green phosphor and the red phosphor is 1: 1. The green phosphor is Ca₃Sc₂Si₃O₁₂: Ce. The red phosphor is CaS: Eu. Since the structure of the device, the choice of the purple light LED, and the way for coating phosphor are all the same to the first embodiment which is already mentioned above, it would not be repeated here.

In a tenth embodiment, for the white light emitting device based on purple light LED, the phosphor layer 5 includes the mixture of yellow phosphor and red phosphor, to enhance the color rendering of the white light emitting device. The weight ratio of the yellow phosphor and the red phosphor is 1: 0.1. The yellow phosphor may be chosen from the LMS series of rare-earth activating silicate phosphor (product number LMS-560), produced by Dalian Luming LED Technology Co., Ltd. in this embodiment. The red phosphor is from Beijing Nakamura-Yuji Science and Technology Co., Ltd, with product No. ZYP650H. Since the structure of the device, the choice of the purple light LED, and the way for coating phosphor are all the same to the first embodiment which is already mentioned above, it will not be repeated here.

In an eleventh embodiment, for the white light emitting device based on purple light LED, the phosphor layer 5 includes the mixture of yellow phosphor and red phosphor, to enhance the color rendering of the white light emitting device. The weight ratio of the yellow phosphor and the red phosphor is 1: 1. The yellow phosphor may be chosen from the LMS series of rare-earth activating silicate phosphor (product number LMS-560), produced by Dalian Luming LED Technology Co., Ltd. The red phosphor is from Beijing Nakamura-Yuji Science and Technology Co., Ltd, with a product No. ZYP650H. Since the structure of the device, the choice of the purple light LED, and the way for coating phosphor are all the same to the first embodiment which is already mentioned above, it will not be repeated here.

## Claims

1. A white light emitting device based on purple light LED, comprising:
a housing;
a support plate received in the housing;
at least one purple light LED semiconductor light source, which has emission wavelength within 210nm-410nm, positioned on the support plate; and
a piece of high silica luminescent glass doped with Eu ions opposite to the purple light LED semiconductor light source, wherein one surface of the high silica luminescent glass away from the purple light LED semiconductor light source is coated with a phosphor layer formed with a selection from a mixture of yellow phosphor and red phosphor, a mixture of green phosphor and red phosphor, and yellow phosphor;
wherein the high silica luminescent glass doped with Eu ions excited by light with wavelength within 210nm-410nm can emit blue light with wavelength within 430-460nm.

2. The white light emitting device based on purple light LED according to claim 1, wherein the thickness of the high silica luminescent glass doped with Eu ions is 0.1mm-50mm.

3. The white light emitting device based on purple light LED according to any of claims 1-2, wherein the yellow phosphor has a maximum emission peak within 530nm-590nm.

4. The white light emitting device based on purple light LED according to claim 3, wherein the yellow phosphor is silicate phosphor which is activated by a wide band, or is a series of rare-earth garnet phosphor which is activated by Cerium.

5. The white light emitting device based on purple light LED according to any of claims 1-2, wherein the green phosphor has an emission maximum within 490nm~525nm.

6. The white light emitting device based on purple light LED according to claim 5, wherein the green phosphor is chloride silicate phosphors or Ca₃Sc₂Si₃O₁₂:Ce green light luminescent material.

7. The white light emitting device based on purple light LED according to any of claims 1-2, wherein the red phosphor is sulfide phosphor or nitride phosphor, which has an emission maximum within 595nm~680nm.

8. The white light emitting device based on purple light LED according to any of claims 1-2, wherein in the mixture of yellow phosphor and red phosphor, the weight ratio of the yellow phosphor and the red phosphor is 1:0.1~1:1.

9. The white light emitting device based on purple light LED according to any of claims 1-2, wherein in the mixture of green phosphor and red phosphor, the weight ratio of the green phosphor and the red phosphor is 1:0.1-1:1.

## Patentansprüche

1. Weißes Licht emittierende Vorrichtung auf Grundlage von Purpurlicht-LED, umfassend:
ein Gehäuse;
eine Trägerplatte, die in dem Gehäuse aufgenommen ist;
zumindest eine Purpurlicht-LED-Halbleiterlichtquelle, deren Emissionswellenlänge im Bereich von 210 nm bis 410 nm liegt und die auf der Trägerplatte angeordnet ist, und
ein Stück hochlumineszentes Quarzglas dotiert mit Eu-lonen gegenüber der Purpurlicht-LED-Halbleiterlichtquelle, wobei eine Oberfläche des hochlumineszenten Quarzglases, die von der Purpurlicht-LED-Halbleiterlichtquelle abgewandt ist, mit einer Phosphorschicht beschichtet ist, die mit einer Auswahl aus einem Gemisch von gelbem und rotem Phosphor, einem Gemisch von grünem und rotem Phosphor und gelbem Phosphor ausgebildet ist,
wobei das mit Eu-lonen dotierte hochlumineszente Quarzglas bei Anregung mit Licht mit einer Wellenlänge im Bereich von 210 nm bis 410 nm blaues Licht mit einer Wellenlänge im Bereich von 430 nm bis 460 nm abgeben kann.

2. Weißes Licht emittierende Vorrichtung auf Grundlage von Purpurlicht-LED nach Anspruch 1, worin die Dicke des mit Eu-lonen dotierten hochlumineszenten Quarzglases 0,1 mm bis 50 mm beträgt.

3. Weißes Licht emittierende Vorrichtung auf Grundlage von Purpurlicht-LED nach einem der Ansprüche 1 bis 2, worin der gelbe Phosphor ein Emissionsmaximum im Bereich von 530 nm bis 590 nm aufweist.

4. Weißes Licht emittierende Vorrichtung auf Grundlage von Purpurlicht-LED nach Anspruch 3, worin der gelbe Phosphor Silicatphosphor ist, der durch ein breites Band aktiviert wird, oder eine Reihe von Seltenerdgranatphosphor ist, die durch Cerium aktiviert wird.

5. Weißes Licht emittierende Vorrichtung auf Grundlage von Purpurlicht-LED nach einem der Ansprüche 1 bis 2, worin der grüne Phosphor ein Emissionsmaximum im Bereich von 490 ~ 525 nm aufweist.

6. Weißes Licht emittierende Vorrichtung auf Grundlage von Purpurlicht-LED nach Anspruch 5, worin der grüne Phosphor Chloridsilicatphosphor oder grünes Licht lumineszierendes Ca₃Sc₂Si₃O₁₂:Ce-Material ist.

7. Weißes Licht emittierende Vorrichtung auf Grundlage von Purpurlicht-LED nach einem der Ansprüche 1 bis 2, worin der rote Phosphor Sulfid- oder Nitridphosphor ist, der ein Emissionsmaximum im Bereich von 595 ~ 680 nm aufweist.

8. Weißes Licht emittierende Vorrichtung auf Grundlage von Purpurlicht-LED nach einem der Ansprüche 1 bis 2, worin in dem Gemisch von gelbem Phosphor und rotem Phosphor das Gewichtsverhältnis von gelbem Phosphor zu rotem Phosphor 1:0,1 ~ 1:1 entspricht.

9. Weißes Licht emittierende Vorrichtung auf Grundlage von Purpurlicht-LED nach einem der Ansprüche 1 bis 2, worin in dem Gemisch von grünem Phosphor und rotem Phosphor das Gewichtsverhältnis von grünem Phosphor zu rotem Phoshpor 1:0,1 ~ 1:1 ist.

## Revendications

1. Dispositif d'émission de lumière blanche basé sur une DEL de lumière pourpre, comprenant :
un boîtier ;
une plaque de support reçue dans le boîtier ;
au moins une source de lumière semi-conductrice DEL de lumière pourpre qui a une longueur d'onde d'émission entre 210nm-410 nm, positionnée sur la plaque de support ; et
une pièce de verre luminescente à haute teneur en silice dopée avec des ions EU opposée à la source de lumière semi-conductrice DEL de lumière pourpre, où une surface du verre luminescent à haute teneur en silice au loin de la source de lumière semi-conductrice DEL de lumière pourpre est revêtue d'une couche de phosphore formée avec une sélection d'un mélange de phosphore jaune et de phosphore rouge, un mélange de phosphore vert et de phosphore rouge, et de phosphore jaune ;
où le verre luminescent à haute teneur en silice dopé avec des ions Eu excité par une lumière d'une longueur d'onde de 210nm-410nm peut émettre de la lumière bleue d'une longueur d'onde de 430-460nm.

2. Dispositif d'émission de lumière blanche basé sur une DEL de lumière pourpre selon la revendication 1, dans lequel l'épaisseur du verre luminescent à haute teneur en silice dopé avec des ions Eu est de 0,1mm-50mm.

3. Dispositif d'émission de lumière blanche basé sur une DEL de lumière pourpre selon l'une quelconque des revendications 1-2, dans lequel le phosphore jaune possède une crête d'émission maximum de 530nm-590nm.

4. Dispositif d'émission de lumière blanche basé sur une DEL de lumière pourpre selon la revendication 3, dans lequel le phosphore jaune est un phosphore de silicate qui est activé par une bande large ou est une série de phosphore de grenat de terre rare qui est activé par le Cérium.

5. Dispositif d'émission de lumière blanche basé sur une DEL de lumière pourpre selon l'une quelconque des revendications 1-2, dans lequel le phosphore vert a un maximum d'émission dans une plage de 490nm~525nm.

6. Dispositif d'émission de lumière blanche basé sur une DEL de lumière pourpre selon la revendication 5, dans lequel le phosphore vert est un phosphore de silicate de chlorure ou un matériau luminescent de lumière verte Ca₃Sc₂Si₃O₁₂: Ce.

7. Dispositif d'émission de lumière blanche basé sur une DEL de lumière pourpre selon l'une quelconque des revendications 1-2, dans lequel le phosphore rouge est le phosphore de sulfure ou le phosphore de nitrure, qui a un maximum d'émission dans une plage de 595nm-680nm.

8. Dispositif d'émission de lumière blanche basé sur une DEL de lumière pourpre selon l'une quelconque des revendications 1-2, dans lequel dans le mélange de phosphore jaune et de phosphore rouge, le rapport pondéral du phosphore jaune et du phosphore rouge est de 1:0,1-1:1.

9. Dispositif d'émission de lumière blanche basé sur une DEL de lumière pourpre selon l'une quelconque des revendications 1-2, dans lequel dans le mélange de phosphore vert et de phosphore rouge, le rapport pondéral du phosphore vert et du phosphore rouge est de 1:0,1-1:1.
